# EUROPÄISCHE PATENTANMELDUNG

(11) **EP 0 802 571 A2**
(43) Veröffentlichungstag der Anmeldung: **22.10.1997**
(21) Anmeldenummer: 97106579.2
(22) Anmeldetag: 21.04.1997
(51) Int. Cl.: H01L 31/112

(54) **Halbleiter-Bauelement bestehend aus einem Feldeffekttransistor und Verfahren zu dessen Herstellung**

(30) Priorität: 19.04.1996 DE 19615495
(71) Anmelder: FORSCHUNGSZENTRUM JÜLICH GMBH, 52425 Jülich (DE)
(72) Erfinder: Marso, Michel, Dr., 52428 Jülich (DE); Horstmann, Manfred, 52428 Jülich (DE); Lüth, Hans, Prof., 52076 Aachen (DE)
(74) Vertreter: Kayser, Reinhild

(57) **Zusammenfassung**

In einem Halbleiter-Bauelement mit einem Substrat und mit einem auf dem Substrat ausgebildeten Feldeffekttransistor bzw. in einem Feldeffekttransistor, bei dem ein durch einen leitenden Halbleiterkanal zwischen einer Sourceelektrode und einer Drainelektrode fließender Strom über ein senkrecht auf den Kanal einwirkendes Feld zwischen einer einzelnen Gateelektrode und dem Kanal steuerbar ist und der eine relativ große aktive Transistorfläche aufweist, sind die Sourceelektrode (9, 9.1), die Drainelektrode (11, 11.1) und die Gateelektrode (7, 7.1) überkreuzungsfrei ausgebildet.

Ein. Verfahren zur Herstellung eines Halbleiter-Bauelementes mit einem Feldeffekttransistor umfaßt die Schritte
Ätzen des Transistors zur Definition einer Transistorfläche,
Aufbringen einer ohmschen Source- und Drainmetallisierung auf einer Oberflächenschicht,
wenigstens teilweises Wegätzen der Oberflächenschicht und Unterätzen der Metallisierungen von Source und Drain,
selbstjustiertes Aufbringen einer Gateelektrode,
Aufbringen von Kontaktanschlüssen.

## Beschreibung

Die vorliegende Erfindung betrifft ein Halbleiter-Bauelement mit einem Substrat und mit einem auf dem Substrat ausgebildeten Feldeffekttransistor bzw. einen Feldeffekttransistor, bei dem ein durch einen leitenden Halbleiterkanal zwischen einer Sourceelektrode und einer Drainelektrode fließender Strom über ein senkrecht auf den Kanal einwirkendes Feld zwischen wenigstens einer Gateelektrode und dem Kanal steuerbar ist und der eine relativ große aktive Transistorfläche aufweist.

Solche Halbleiter-Bauelemente sind aus dem allgemeinen Stand der Technik bekannt und umfassen z. B. einfache Feldefekttransistoren (FETs), Metall-Halbleiter-Feldeffekttransistoren (MESFETs), die nach dem Prinzip des Sperrschichtfeldeffekttransistors arbeiten, bei dem anstelle des steuernden pn-Überganges ein Schottky-Übergang verwendet wird, Feldeffekttransistoren mit Metail-Isolator-Halbleiterübergang (MISFETs). Feldeffekttransistoren mit isolierendem Gate (MOSFETs) oder extrem schnelle und rauscharme Feldeffekttransistoren, die die hohe Beweglichkeit eines zweidimensionalen Elektronengases ausnutzen (HEMTs).

Für ein gutes Hochfrequenzverhalten. d. h., eine große Schnelligkeit, ist es für solche elektrisch gesteuerte Feldeffekttransistoren wichtig, daß der Gatewiderstand minimiert ist. Die Gatelänge eines elektrisch gesteuerten hochfrequenztauglichen Transistors liegt in der Größenordnung von 1 µm. Deshalb müssen mehrere Gates parallel angeordnet werden, um eine sinnvolle aktive Transistorfäche zu erhalten. Um Source-, Gate- und Drainstreifen einer solchen Anordnung zu kontaktieren, sind bei der konventionellen, auf minimalen Gatemetallisierungswiderstand ausgelegten Technologie Isolationsebenen oder Luftbrücken erforderlich.

Optoelektronisch gesteuerte Bauelemente, wie z. B. optoelektronische Empfänger, bestehen in der Regel aus einem optoelektronischen Detektor (z.B. MSM- oder PIN-Diode) und einer nachfolgenden elektrischen Verstärkerschaltung. Die elektrische Verbindung zwischen Empfänger und Verstärker verschlechtert die Eigenschaften der Empfängers durch parasitäre Widerstände, Indukuvitäten und Kapazitäten und durch Rauschbeiträge. Durch die Integration des optoelektronischen Detektors und der ersten Verstärkerstufe in einem Bauelement kann diese Qualitätsverminderung verhindert werden. Außerdem verringert sich der Herstellungsaufwand. Ein solches Bauelement ist der OPFET. Das Licht gelangt durch ein transparentes oder semitransparentes Gate oder durch die Waferrückseite in die Steuerzone eines Feldeffekttransistors und erzeugt dort Elektronen-Loch-Paare. Durch diese elektrische Änderung der Gate-Steuerstrecke wird der Drainstrom des Transistors beeinflußt.

Während bei herkömmlichen Feldeffektransistoren mit elektrischer Steuerung der Widerstand der Gatemetallisierung möglichst klein sein muß, um ein gutes Hochfrequenzverhalten zu erhalten, spielt der Widerstand der Gatemetallisierung beim OPFET keine Rolle für die Geschwindigkeit, weil die elektrische Anregung im Innern des Transistors stattfindet. Deshalb braucht das Transistordesign im Gegensatz zum klassischen Transistor nicht auf einen minimalen Gatewiderstand optimiert zu werden. Die herkömmliche Bauweise ist somit zumindest für diese Verwendungsart der Feldeffekttransistoren nachteilig.

Die Aufgabe der vorliegenden Erfindung ist daher, ein Halbleiter-Bauelement bzw. einen Feldeffekttransistor zu schaffen, der bei konstruktiv einfacher Bauweise eine relativ große aktive Transistorfläche aufweist.

Die Aufgabe wird gemäß Anspruch 1 dadurch gelöst, daß die Sourceelektrode, die Drainelektrode und die Gateelektrode überkreuzungsfrei ausgebildet sind und gemäß Anspruch 7 durch einen Feldeffekttransistor mit überkreuzungsfreien Source-, Drain- und Gateelektroden gelöst.

Eine weitere Aufgabe der vorliegenden Erfindung ist, ein Verfahren zur leichteren Herstellung eines Halbleiter-Bauelementes mit einem Feldeffekttransistor zu schaffen.

Diese Aufgabe wird gelöst durch Ätzen des Transistors zur Definition einer Transistorfläche: Aufbringen einer ohmschen Source- und Drainmetallisierung auf einer Oberflächenschicht; wenigstens teilweises Wegätzen der Oberflächenschicht und Unterätzen der Metallisierungen von Source und Drain; selbstjustiertes Aufbringen einer Gateelektrode; Aufbringen von Kontaktanschlüssen.

Das zu detektierende Licht z.B. aus einer Glasfaser hat im Normalfall einen Spotdurchmesser von einigen 10 µm. Konventionelle MSM-Detektoren haben eine Fläche von typisch 50 µm · 50 µm, um einen Großteil des Lichtes aus der Glasfaser zu sammeln und um die Justierung der Glasfaser zu erleichtern. Die aktive Transistorfläche eines OPFETs sollte deshalb auch in etwa diese Abmessungen haben. Der Vorteil gemäß Anspruch 1 und 7 liegt darin, daß die überkreuzungsfreie Anordnung der einzelnen Elektroden eine Grundvoraussetzung für eine bessere Anpassung der Transistorfläche an diese gegebenen Umstände ermöglicht.

Eine besonders günstige Wirkungsweise des Halbleiter-Bauelementes wird erreicht, wenn gemäß Anspruch 2 und 8 die Gateelektrode mäanderförmig und die Source- und Drainelektrode jeweils fingerförmig ineinandergreifend ausgebildet sind.

Weitere Vorteile der vorliegenden Erfindung ergeben sich aus den Merkmalen der Unteransprüche 3 bis 6 und 9 bis 12.

Das erfindungsgemäße Verfahren gemäß Anspruch 13 hat den Vorteil, daß die Verwendung eines selbstjustierenden Prozesses und die Wirkungsweise der Source- und Drainelektroden als Maske für das Aufbringen der Gateelektrode die Herstellung wesentlich erleichtern.

Weitere vorteilhafte Ausgestaltungen des erfindungsgemäßen Verfahrens sind in den Unteransprüchen 14 bis 17 angeführt.

Eine Ausführungsform der vorliegenden Erfindung wird im folgenden anhand der Zeichnungen näher beschrieben. Es zeigen:
- Fig. 1: eine vereinfachte perspektivische Ansicht eines Halbleiter-Bauelementes gemäß der vorliegenden Erfindung;
- Fig. 2a: eine vereinfachte Schnittdarstellung des erfindungsgemäßen Halbleiter-Bauelementes unmittelbar nach einem Verfahrensschritt "Unterätzen der Oberflächenschicht";
- Fig. 2b: eine vereinfachte Schnittdarstellung entsprechend Fig. 2a nach dem Verfahrensschritt "Selbstjustiertes Aufbringen der Gateelektrode".

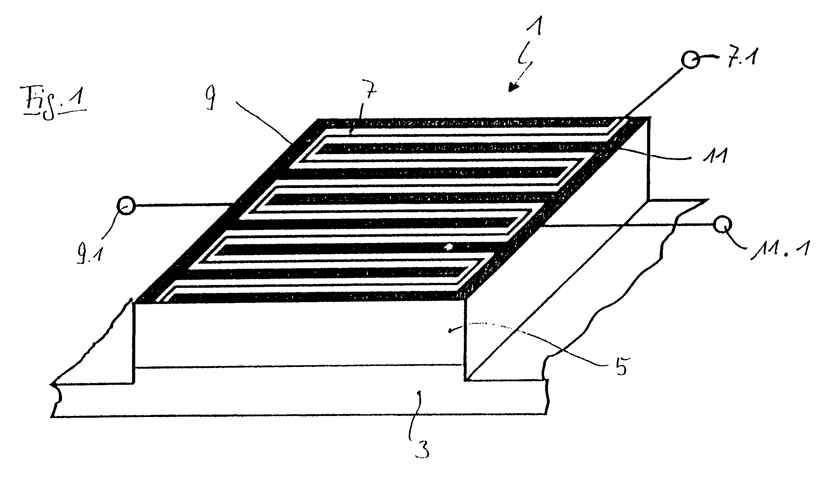

In Fig. 1 ist vereinfacht eine perspektivische Ansicht eines erfindungsgemäßen Halbleiter-Bauelementes 1 als integrierter FET-Phototransistor dargestellt. Auf einem Substrat 3 ist ein leitender Halbleiterkanal 5 entsprechend dem verwendeten Feldeffekttransistor (FET, MESFET, MISFET, MOSFET, HEMT) ausgebildet. Auf der Oberseite des Halbleiterkanals 5 ist eine Gateelektrode 7 mit einem Gateanschluß 7.1 in mäandrierender Form angeordnet. Eine Sourcceelektrode 9 mit einem Sourceanschluß 9.1 erstreckt sich fingerförmig auf der linken Seite in Fig. 1, und eine entsprechend fingerförmig ausgebildete Drainelektrode 11 mit einem Drainanschluß 11.1 erstreckt sich auf der rechten Seite in Fig. 1. Die Sourceelektrode 9 und Drainelektrode 11 sind so ausgerichtet, daß die ausgebildeten Finger ineinandergreifen.

Aufgrund der Ausführung des Bauelementes 1 als FET-Phototransistor ist die Gateelektrode 7 aus einem transparenten oder semitransparenten Material hergestellt. In der vorliegenden Ausführungsform soll das Bauelement 1 eine in etwa quadratische aktive Transistorfläche aufweisen, vorzugsweise in einer Größe von 50 µm · 50 µm. In anderen Ausführungsformen kann die aktive Transistorfläche aber auch andere Abmessungen aufweisen, die dem jeweiligen Bedarf angepaßt sind.

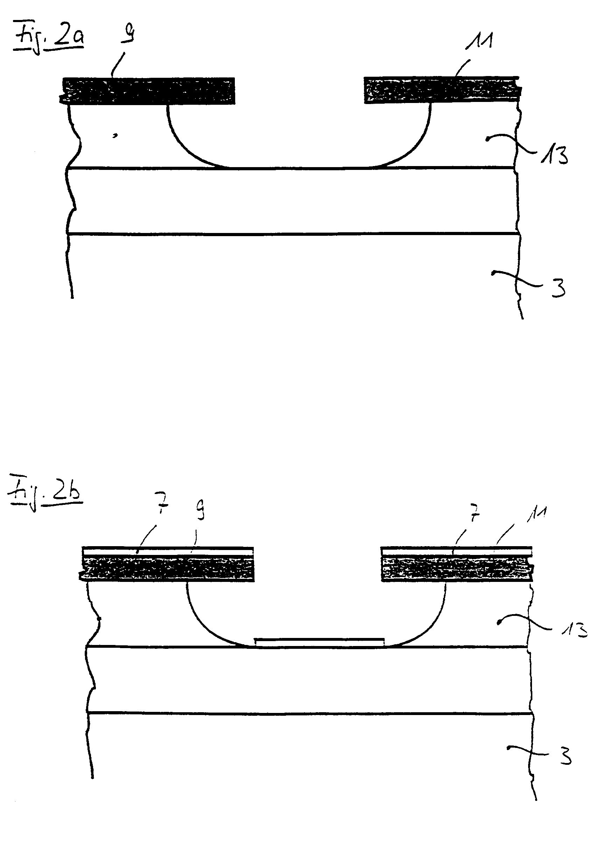

In Fig. 2a und Fig. 2b sind vereinfacht zwei Verfahrensschritte bei der Herstellung des erfindungsgemäßen Bauelementes 1 dargestellt.

Das Herstellungsverfahren läuft wie folgt ab:
1. Mesaätzung zur Definition der Transistorfläche.
2. Aufbringen der fingerförmigen Drain-und Source- Metallisierungen 9, 11.
3. Wegätzen einer Oberflächenschicht 13 mit Unterätzung unter die Metallkontakte 9, 11 (Fig. 2a). Die Oberflächenschicht 13 wird normalerweise zur Verbesserung des ohmschen Kontaktes von Source 9 und Drain 11 benutzt (z. B. beim HEMT). Anderenfalls kann eine Oberflächenschicht 13 aufgebracht werden, welche den ohmschen Kontakt nicht verschlechtert, und selektiv zum Halbleitermaterial und zur ohmschen Metallisierung weggeätzt werden kann. Die Oberflächenschicht 13 sollte so dick gewählt werden, daß die nachfolgende Gatemetallisierung 7 keinen Kurzschluß zu den ohmschen Kontakten erzeugt.
4. Selbstjustiertes Aufbringen der transparenten oder semitransparenten Gateelektrode (Fig. 2b).
5. Aufbringen der Kontaktanschlüsse 7.1, 9.1, 11.1.

Zusammenfassend soll das Gate 7 eines Feldeffekttransistors (FET, MESFET, MISFET, MOSFET, HEMT) als Mäander, mit fingerförmigen Source- und Drainelektroden 9, 11 eines Bauelementes 1 ausgeführt werden. Ziel dieses Layouts ist eine mehr oder weniger quadratische aktive Fläche des Bauelementes 1, um das Licht eines Lichtspots, z.B. aus einem Glasfaserkabel, möglichst effektiv zu nutzen.

Ferner soll das Gate 7 des Bauelementes 1 aus transparentem oder semitransparenten Material ausgeführt sein, um das zu detektierende Licht durch die Gatemetallisierung in die Transistorzone mit Steuerwirkung zu leiten.

Weiterhin soll das Bauelement 1 mit einem selbstjustierenden Prozeß hergestellt werden, wobei die fingerförmigen Source- und Drainelektroden 9, 11 als Maske für das Aufbringen der Gateelektrode 7 dienen.

## Patentansprüche

1. Halbleiter-Bauelement mit einem Substrat und mit einem auf dem Substrat ausgebildeten Feldeffekttransistor, bei dem ein durch einen leitenden Halbleiterkanal zwischen einer Sourceelektrode und einer Drainelektrode fließender Strom über ein senkrecht auf den Kanal einwirkendes Feld zwischen einer einzelnen Gateelektrode und dem Kanal steuerbar ist und der eine relativ große aktive Transistorfläche aufweist.
**dadurch gekennzeichnet,**
daß die Sourceelektrode (9, 9.1), die Drainelektrode (11, 11.1) und die Gateelektrode (7, 7.1) überkreuzungsfrei ausgebildet sind.

2. Halbleiter-Bauelement nach Anspruch 1,
**dadurch gekennzeichnet,**
daß die Gateelektrode (7) zwischen der Sourceelektrode (9) und der Drainelektrode (11) mäanderförmig ausgebildet ist und die Sourceelektrode (9) und die Drainelektrode (11) entsprechend der Mäanderform jeweils fingerförmig ineinandergreifen.

3. Halbleiter-Bauelement nach Anspruch 1 oder 2,
**dadurch gekennzeichnet,**
daß die Gateelektrode (7) aus einem semitransparenten Material hergestellt ist.

4. Halbleiter-Bauelement nach Anspruch 1 oder 2,
**dadurch gekennzeichnet,**
daß die Gateelektrode (7) aus einem transparenten Material hergestellt ist.

5. Halbleiter-Bauelement nach einem der Anspruch 1-4,
**dadurch gekennzeichnet,**
daß der Feldeffekttransistor eine in etwa quadratische aktive Fläche aufweist.

6. Halbleiter-Bauelement nach einem der vorstehenden Ansprüche,
**dadurch gekennzeichnet,**
daß der Feldeffekttransistor ein optisch gesteuerter Feldeffekttransistor (OPFET) ist.

7. Feldeffekttransistor mit überkreuzungsfreien Source-, Drain- und Gateelektroden (9, 9.1; 11, 11.1; 7, 7.1).

8. Feldeffekttransistor nach Anspruch 7,
**dadurch gekennzeichnet,**
daß die Gateelektrode (7) zwischen der Sourceelektrode (9) und der Drainelektrode (11) mäanderförmig ausgebildet ist und die Sourceelektrode (9) und die Drainelektrode (11) entsprechend der Mäanderform jeweils fingerförmig ineinandergreifen.

9. Feldeffekttransistor nach Anspruch 7 oder 8,
**dadurch gekennzeichnet,**
daß die Gateelektrode (7) aus einem semitransparenten Material hergestellt ist.

10. Feldeffekttransistor nach Anspruch 7 oder 8,
**dadurch gekennzeichnet,**
daß die Gateelektrode (7) aus einem transparenten Material hergestellt ist.

11. Feldeffekttransistor nach einem der Anspruch 7-10,
**dadurch gekennzeichnet,**
daß der Feldeffekttransistor eine in etwa quadratische aktive Fläche aufweist.

12. Feldeffekttransistor nach einem der vorstehenden Ansprüche,
**dadurch gekennzeichnet,**
daß der Feldeffekttransistor ein optisch gesteuerter Feldeffekttransistor (OPFET) ist.

13. Verfahren zur Herstellung eines Halbleiter-Bauelementes mit einem Feldeffekttransistor,
**gekennzeichnet durch**
Ätzen des Transistors zur Definition einer Transistorfläche,
Aufbringen einer ohmschen Source- und Drainmetallisierung auf einer Oberflächenschicht,
wenigstens teilweises Wegätzen der Oberflächenschicht und Unterätzen der Metallisierungen von Source und Drain,
selbstjustiertes Aufbringen einer Gateelektrode,
Aufbringen von Kontaktanschlüssen.

14. Verfahren nach Anspruch 13,
**dadurch gekennzeichnet,**
daß die Oberflächenschicht in Abhängigkeit vom ohmschen Kontakt zwischen der Source- und der Drainelektrode ausgewählt wird.

15. Verfahren nach Anspruch 14,
**dadurch gekennzeichnet,**
daß die Oberflächenschicht selektiv zum Halbleitermaterial und zur ohmschen Metallisierung weggeätzt wird.

16. Verfahren nach einem der Ansprüche 13-15,
**dadurch gekennzeichnet,**
daß die Dicke der Oberflächenschicht so gewählt wird, daß die nachfolgende Gatemetallisierung kurzschlußfrei zu den ohmschen Kontakten erzeugt wird.

17. Verfahren nach einem der Ansprüche 13-16,
**dadurch gekennzeichnet,**
daß die Gateelektrode transparent oder semitransparent ausgebildet wird.
